# EUROPÄISCHE PATENTSCHRIFT

(11) **EP 0 824 644 B1**
(45) Veröffentlichungstag und Bekanntmachung des Hinweises auf die Patenterteilung: **30.09.1998**
(21) Anmeldenummer: 96919693.0
(22) Anmeldetag: 07.05.1996
(51) Int. Cl.: F16H 61/00, B60R 16/02, H05K 7/20

(54) **KÜHLUNG FÜR EINE GETRIEBESTEUERUNG**
GEAR BOX CONTROL COOLING
REFROIDISSEMENT DE LA COMMANDE D'UNE BOITE DE VITESSES

(30) Priorität: 12.05.1995 DE 19517491
(43) Veröffentlichungstag der Anmeldung: 25.02.1998
(73) Patentinhaber: ZF FRIEDRICHSHAFEN Aktiengesellschaft, 88038 Friedrichshafen (DE)
(72) Erfinder: FESSLER, Bernhard, D-88048 Friedrichshafen (DE); SCHWARZ, Josef, D-88045 Friedrichshafen (DE); BIRKENMAIER, Gerhard, D-88074 Meckenbeuren (DE)
(86) Internationale Anmeldenummer: EP9601898
(87) Internationale Veröffentlichungsnummer: WO9635894

(56) Entgegenhaltungen:
- DE-A- 3 307 654
- DE-U- 9 307 228
- FR-A- 2 621 869

## Beschreibung

Die Erfindung betrifft eine elektronische Steuerung für Getriebe von Kraftfahrzeugen gemäß Oberbegriff des Anspruchs 1.

Bei Schaltgetrieben wird zunehmend die Elektronik zur Steuerung der Schaltabläufe eingesetzt. Es ist von Vorteil, wenn die Elektronik am oder im Getriebe untergebracht ist. Dabei wird die Elektronik allerdings extremen Umweltbedingungen ausgesetzt.

Aus dem deutschen Gebrauchsmuster G 93 07 228 ist eine Getriebesteuerung bekannt, die innerhalb des Getriebegehäuses angeordnet ist. Die Steuerung kann dabei vom Getriebeöl umgeben sein und über Kühlelemente Wärme an das Öl abgeben. Die Kühlung der Steuerung wird im wesentlichen durch das Getriebeöl übernommen. Schäden an der Getriebesteuerung können in dieser Anordnung nur behoben werden, wenn das Getriebe vom Fahrzeug entfernt und demontiert wird. Dadurch wird ein enormer Kundendienstaufwand gefordert, der in keinem Verhältnis zum Austausch von eventuell billigen elektronischen Bauteilen steht. Die Elektronik ist ständig von aggressivem Getriebeöl umspült, was bei Beschädigungen der Abdichtung oder Lackierung zu Funktionsstörungen der Elektronik führt.

Der Erfindung liegt daher die Aufgabe zugrunde, eine Getriebesteuerung vorzusehen, bei der die Kühlung der Elektronik vereinfacht und sicher ist.

Die Aufgabe wird durch eine Getriebesteuerung mit den Merkmalen des Anspruchs 1 gelöst. Ausgestaltungen sind Gegenstand von Unteransprüchen.

Die Elektronik der Getriebesteuerung eines automatischen oder automatisierten Getriebes wird außen am Getriebegehäuse angeordnet. Dabei befindet sie sich vorteilhafterweise im Bereich der Steuermittel zum Betreiben des Getriebes. Zu diesen Steuermitteln sind durch Fluide betätigte Stellglieder zu zählen, insbesondere hydraulische oder pneumatische Stellglieder. Bei pneumatischen Stellgliedern werden diese entsprechend einer Ansteuerung zum Betätigen von Getriebeelementen mit Druckluft aus einem Druckluftvorratsbehältnis versorgt. Bei hydraulischen Stellgliedern geschieht dies entsprechend mit einem Hydrauliköl aus einem Ölvorrat. Vorzugsweise wird Luft als Steuerfluid verwendet, dennoch sind nachfolgende Betrachtungen entsprechend auch für hydraulische Stellglieder anwendbar, wobei eine angepaßte Abdichtung und gegebenenfalls Kühleinrichtung für das Hydrauliköl vorzusehen ist.

Bei dem Betätigen eines pneumatischen Stellgliedes mit zwei Kammern wird Luft in eine Kammer eingeführt und ein Stellkolben, der die beiden Kammern des Stellgliedes trennt, derart bewegt, daß er die Luft aus der jeweils anderen Kammer herauspreßt. Diese Luft wird erfindungsgemäß zur Kühlung der Elektronik herangezogen. Dabei kann sowohl die herausgepreßte Abluft als auch die zuströmende Steuerluft verwendet werden.

Es können drei Arten der Luftbeaufschlagung zur Kühlung unterschieden werden:
1. die abgeblasene Luft wird direkt zum Anblasen der zu kühlenden Bauteile von außen im einzelnen oder als Gesamtheit verwendet;
2. die Elektronikbauteile oder Baugruppen sind derart aufgebaut, daß die Luft sie durchströmen kann;
3. die Luft durchströmt eine Kühlplatte, die mit der Elektronik derart verbunden ist, daß Wärme von den elektronischen Bauteilen im einzelnen oder als Gesamtheit auf diese Kühlplatte übertragen werden kann.

Im ersten und zweiten Fall wird die Temperatur durch die angeblasene oder durchgeblasene Luft abgeführt. Im zweiten Fall nimmt zunächst die Kühlplatte die Temperatur auf und gibt sie dann an die vorbeiströmende Luft ab.

Der Zeitpunkt der Luftströmung kann auf verschiedene Arten einzeln oder auch in Kombination vorgenommen werden:
1. die Kühlluft wird den Bauteilen oder der Baugruppe dauernd zugeführt;
2. die Kühlluft wird nur während der Betätigung der pneumatischen Stellglieder den Bauteilen oder Baugruppen zugeführt;
3. die Kühlluft wird in Abhängigkeit einer gemessenen Temperatur nach Überschreitung einer Grenztemperatur den Bauteilen oder Baugruppen zugeführt;
4. die Kühlluft wird nach Abstellen des Fahrzeugs zugeführt, um Stauwärme abzuführen.

Der Dauerluftstrom nach Punkt 1 wird über eine Drosseleinrichtung reguliert zugeführt. Eine temperaturabhängige Zuführung nach Punkt 3 erfolgt über temperaturgesteuerte Schalteinrichtungen, die gegebenenfalls eine Zwangsluftzuführung, beispielsweise über Ventilatoren, gewährleisten.

Bei Punkt 4 wird ebenfalls eine Zwangsluftzuführung, beispielsweise über Ventilatoren, vorgenommen.

Die elektronischen Bauteile können mittels einer wärmeisolierenden Sperrschicht gegenüber der sonstigen Steuereinrichtung oder auch anderen angrenzenden Bauteilen des Getriebes isoliert sein, so daß ein Wärmetransport in Richtung auf die elektronischen Bauteile unterbrochen wird.

Die Erfindung wird anhand von Figuren näher beschrieben.
Es zeigen:
- Fig. 1: ein Fahrzeuggetriebe mit angeordneter Steuereinrichtung;
- Fig. 2: eine schematische Steuereinrichtung mit angeblasener Luft und
- Fig. 3: eine schematische Steuereinrichtung mit Kühlplatte.

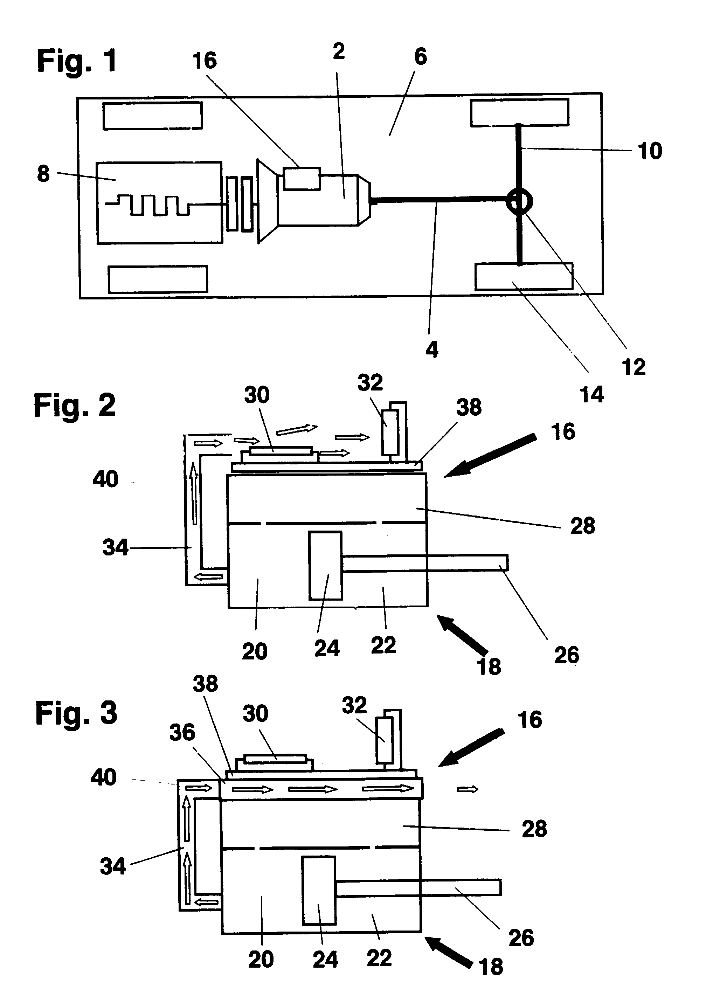

Die Fig. 1 zeigt ein schematisiertes Fahrzeuggetriebe 2, das in einem Antriebsstrang 4 eines Fahrzeugs 6 zwischen einem Antriebsmotor 8 und einer Abtriebswelle 10 mit Differential 12 und nachgeordneten Rädern 14 vorgesehen ist. An dem Fahrzeuggetriebe 2 ist eine Steuereinrichtung 16 vorgesehen, die vorzugsweise so angeordnet ist, daß Teile der Steuereinrichtung 16 in das Fahrzeuggetriebe 2 hineinragen und dort mit hier nicht gezeigten Stellgliedern der Schalteinrichtungen des Getriebes zusammenwirken.

Die Fig. 2 zeigt in einer schematischen Darstellung eine Vergrößerung der Steuereinrichtung 16. Die Zylindereinheit 18 weist zwei Kammern 20 und 22 auf, die durch einen Kolben 24 getrennt sind. An dem Kolben 24 ist eine Schubstange 26 vorgesehen, die mit hier nicht gezeigten Schalteinrichtungen der Getriebeschaltung zusammenwirkt. Über eine nicht näher beschriebene Einheit mit Stellgliedern 28 werden die Kammern 20 und 22 jeweils mit Luft versorgt. Die schematischen elektronischen Bauteile 30 und 32 auf einer Platine 38 zur Steuerung der Aktuatoreinheit 28 sind hier unmittelbar an der Aktuatoreinheit 28 angeordnet.

Wird in der hier gezeigten Anordnung die Kammer 22 belüftet, so wird der Kolben 24 nach links bewegt und verdrängt Luft 40 aus der Kammer 20. Diese Luft 40 wird über eine Zuführung 34 derart an die Bauteile 30 und 32 herangeführt, daß die Luft über die Bauteile 30 und 32 hinwegstreicht und die Wärme an die Umgebung abführt.

Die Fig. 3 zeigt, ausgehend von der Fig. 2, eine Kühlplatte 36, die zwischen der Aktuatoreinheit 28 und den Bauteilen 30 und 32 vorgesehen ist. Die Kühlplatte 36 nimmt die von den Bauteilen 30 und 32 erzeugte Wärme auf. Zwischen der Platine 38 und der Kühlplatte 36 können Mittel zur Verbesserung der Wärmeleitfähigkeit vorgesehen sein. Ein solches Mittel stellt beispielsweise eine Wärmeleitpaste dar. Die durch die Zuführung 34 herangeführte Luft 40 wird durch die Kühlplatte 36 geleitet und führt die von der Kühlplatte 36 aufgenommene Wärme an die Umgebung ab.

### Bezugszeichen

- 2: Fahrzeuggetriebe
- 4: Antriebsstrang
- 6: Fahrzeug
- 8: Antriebsmotor
- 10: Abtriebswelle
- 12: Differential
- 14: Räder
- 16: Steuereinrichtung
- 18: Zylindereinheit
- 20: Kammer
- 22: Kammer
- 24: Kolben
- 26: Schubstange
- 28: Aktuatoreinheit
- 30: Bauteil
- 32: Bauteil
- 34: Zuführung
- 36: Kühlplatte
- 38: Platine
- 40: Luft

## Patentansprüche

1. Steuereinrichtung (16) mit mit einem Steuerfluid (40) betätigten Steuermitteln (16, 18) und mit einer funktional zugeordneten Steuerelektronik (30, 32, 38), insbesondere Getriebesteuereinrichtung für ein Kraftfahrzeug (6) mit einem Getriebe (2), wobei die Steuerelektronik (30, 32, 38) in oder an dem Getriebe (2) angeordnet ist, dadurch **gekennzeichnet**, daß die Steuerelektronik (30, 32, 38) durch gezielte Zuführung des Steuerfluids (40) zwangsgekühlt ist.

2. Steuereinrichtung (16) nach Anspruch 1, dadurch **gekennzeichnet**, daß die Fluidzufuhr derart gestaltet ist, daß das Steuerfluid (40) bei der Betätigung der Steuermittel (16, 18) der Getriebeschaltung zugeführt wird.

3. Steuereinrichtung (16) nach Anspruch 1, dadurch **gekennzeichnet**, daß die Fluidzufuhr derart gestaltet ist, daß das Steuerfluid (40) ständig zugeführt wird.

4. Steuereinrichtung (16) nach Anspruch 1, dadurch **gekennzeichnet**, daß die Fluidzufuhr derart gestaltet ist, daß das Steuerfluid (40) temperaturabhängig zugeführt wird.

5. Steuereinrichtung (16) nach einem der Ansprüche 1 bis 4, als Getriebesteuereinrichtung für ein Kraftfahrzeug (6) mit einem Getriebe (2), wobei die Steuerelektronik (30, 32, 38) in oder an das Getriebe (2) angeordnet ist, dadurch **gekennzeichnet**, daß die Zufuhr des Steuerfluids (40) nach Abstellen des Fahrzeugs (6) fortsetzbar ist.

6. Steuereinrichtung (16) nach einem der Ansprüche 1 bis 5, dadurch **gekennzeichnet**, daß die Steuerelektronik (30, 32, 38) derart ausgestaltet ist, daß das Steuerfluid (40) die Steuerelektronik (30, 32, 38) durchströmt.

7. Steuereinrichtung (16) nach einem der Ansprüche 1 bis 5, dadurch **gekennzeichnet**,daß die Steuerelektronik (30, 32, 38) auf einer von dem Steuerfluid (40) durchströmten Kühlplatte (36) angeordnet ist.

8. Steuereinrichtung (16) nach Anspruch 7, dadurch **gekennzeichnet**, daß Mittel zwischen Steuerelektronik (30, 32, 38) und Kühlplatte (36) vorgesehen sind, die die Wärmeleitfähigkeit verbessern.

9. Steuereinrichtung (16) nach Anspruch 8, dadurch **gekennzeichnet**, daß das Mittel eine Wärmeleitpaste ist.

10. Steuereinrichtung (16) nach einem der Ansprüche 1 bis 9, dadurch **gekennzeichnet**,daß das Steuerfluid (40) durch eine Fördereinrichtung zwangsgeführt ist.

11. Steuereinrichtung (16) nach Anspruch 10, dadurch **gekennzeichnet**, daß die Fördereinrichtung ein Ventilator ist.

12. Steuereinrichtung (16) nach Anspruch 10, dadurch **gekennzeichnet**, daß die Fördereinrichtung eine Pumpe ist.

13. Steuereinrichtung (16) nach wenigstens einem der vorherigen Ansprüche, dadurch **gekennzeichnet**, daß das Steuerfluid (40) Luft ist.

14. Steuereinrichtung (16) nach wenigstens einem der vorherigen Ansprüche 1 bis 12, dadurch **gekennzeichnet**, daß das Steuerfluid (40) Hydrauliköl ist.

15. Steuereinrichtung nach wenigstens einem der vorherigen Ansprüche, dadurch **gekennzeichnet**, daß die Steuerelektronik (30, 32, 38) gegenüber sonstigen Bauteilen der Steuereinrichtung (16, 18) oder des Getriebes (2) wärmeisoliert ausgeführt ist.

16. Verfahren zur Kühlung der Elektronik (30, 32, 38) einer Steuereinrichtung (16) mit mit einem Steuerfluid (40) betätigten Steuermitteln (16, 18), insbesondere einer Getriebesteuereinrichtung für ein Kraftfahrzeug (6) mit einem Getriebe (2), dadurch **gekennzeichnet**, daß gezielt zwangsgeführt das Steuerfluid (40) zur Kühlung in den Bereich der Elektronik (30, 32, 38) geleitet wird.

17. Verfahren zur Kühlung der Elektronik (30, 32, 38) einer Steuereinrichtung (16) nach Anspruch 15, dadurch **gekennzeichnet**, daß das Steuerfluid (40) beim Betätigen der Steuermittel (16, 18) in den Bereich der Elektronik (30, 32, 38) geleitet wird.

18. Verfahren zur Kühlung der Elektronik (30, 32, 38) einer Steuereinrichtung (16) nach Anspruch 15, dadurch **gekennzeichnet**, daß das Steuerfluid (40) ständig in den Bereich der Elektronik (30, 32, 38) geleitet wird.

19. Verfahren zur Kühlung der Elektronik (30, 32, 38) einer Steuereinrichtung (16) nach Anspruch 15, dadurch **gekennzeichnet**, daß die Temperatur im Bereich der Elektronik (30, 32, 38) gemessen und das Steuerfluid (40) nach Überschreitung einer Grenztemperatur in den Bereich der Elektronik (30, 32, 38) geleitet wird.

20. Verfahren zur Kühlung der Elektronik (30, 32, 38) einer Steuereinrichtung (16) nach einem der Ansprüche 15 bis 18, als Getriebesteuereinrichtung für ein Kraftfahrzeug (6) mit einem Getriebe (2), wobei die Steuerelektronik (30, 32, 38) in oder an das Getriebe (2) angeordnet ist, dadurch **gekennzeichnet**, daß die Zufuhr des Steuerfluids (40) nach Abstellen des Fahrzeugs (6) fortgesetzt wird, um Stauwärme im Bereich der Elektronik (30, 32, 38) abzuführen.

21. Verfahren zur Kühlung der Elektronik (30, 32, 38) einer Steuereinrichtung (16) nach wenigstens einem der Ansprüche 15 bis 19, dadurch **gekennzeichnet**, daß das Steuerfluid (40) durch eine Kühlplatte (36) geleitet wird, auf der die Elektronik (30, 32, 38) angeordnet ist.

22. Verfahren zur Kühlung der Elektronik (30, 32, 38) einer Steuereinrichtung (16) nach wenigstens einem der Ansprüche 15 bis 20, dadurch **gekennzeichnet**, daß das Steuerfluid (40) mit fluidfördernden Mitteln in den Bereich der Elektronik (30, 32, 38) geleitet wird.

23. Verfahren zur Kühlung der Elektronik (30, 32, 38) einer Steuereinrichtung (16) nach Anspruch 21, dadurch **gekennzeichnet**, daß das Steuerfluid (40) von einem Ventilator gefördert wird.

24. Verfahren zur Kühlung der Elektronik (30, 32, 38) einer Steuereinrichtung (16) nach Anspruch 21, dadurch **gekennzeichnet**, daß das Steuerfluid (40) mit einer Pumpe gefördert wird.

25. Verfahren zur Kühlung der Elektronik (30, 32, 38) einer Steuereinrichtung (16) nach wenigstens einem der Ansprüche 15 bis 23, dadurch **gekennzeichnet**, daß als Steuerfluid (40) Luft verwendet wird.

26. Verfahren zur Kühlung der Elektronik (30, 32, 38) einer Steuereinrichtung (16) nach wenigstens einem der Ansprüche 15 bis 23, dadurch **gekennzeichnet**, daß als Steuerfluid Hydrauliköl verwendet wird.

## Claims

1. Control device (16) having control means (16, 18) operated by a control fluid (40) and having functionally associated control electronics (30, 32, 38), in particular a gearbox control device for a motor vehicle (6) having a gearbox (2), the control electronics (30, 32, 38) being disposed in or at the gearbox (2), characterized in that the control electronics (30, 32, 38) are forced-cooled by purposeful supply of the control fluid (40).

2. Control device (16) according to claim 1,
characterized in that the fluid supply is designed in such a way that the control fluid (40) upon operation of the control means (16, 18) is supplied to the gear change device.

3. Control device (16) according to claim 1,
characterized in that the fluid supply is designed in such a way that the control fluid (40) is constantly supplied.

4. Control device (16) according to claim 1,
characterized in that the fluid supply is designed in such a way that the control fluid (40) is supplied in a temperature-dependent manner.

5. Control device (16) according to one of claims 1 to 4, as a gearbox control device for a motor vehicle (6) having a gearbox (2), the control electronics (30, 32, 38) being disposed in or at the gearbox (2),
characterized in that the supply of the control fluid (40) may continue after parking of the vehicle (6).

6. Control device (16) according to one of claims 1 to 5,
characterized in that the control electronics (30, 32, 38) are refined in such a way that the control fluid (40) flows through the control electronics (30, 32, 38).

7. Control device (16) according to one of claims 1 to 5,
characterized in that the control electronics (30, 32, 38) are disposed on a cooling plate (36), through which the control fluid (40) flows.

8. Control device (16) according to claim 7,
characterized in that means of improving the thermal conductivity are provided between control electronics (30, 32, 38) and cooling plate (36).

9. Control device (16) according to claim 8,
characterized in that the means is a heat transfer compound.

10. Control device (16) according to one of claims 1 to 9,
characterized in that the control fluid (40) is conveyed in a forced manner by means of a feed device.

11. Control device (16) according to claim 10,
characterized in that the feed device is a fan.

12. Control device (16) according to claim 10,
characterized in that the feed device is a pump.

13. Control device (16) according to at least one of the preceding claims, characterized in that the ccntrol fluid (40) is air.

14. Control device (16) according to at least one of the preceding claims 1 to 12, characterized in that the control fluid (40) is hydraulic oil.

15. Control device according to at least one of the preceding claims, characterized in that the control electronics (30, 32, 38) are designed to be thermally insulated from other components of the control device (16, 18) or of the gearbox (2).

16. Method of cooling the electronics (30, 32, 38) of a control device (16) having control means (16, 18) operated by a control fluid (40), in particular a gearbox control device for a motor vehicle (6) having a gearbox (2), characterized in that in a purposefully forced-fed manner the control fluid (40) for cooling is directed into the region of the electronics (30, 32, 38).

17. Method of cooling the electronics (30, 32, 38) of a control device (16) according to claim 15,
characterized in that the control fluid (40) upon operation of the control means (16, 18) is directed into the region of the electronics (30, 32, 38).

18. Method of cooling the electronics (30, 32, 38) of a control device (16) according to claim 15,
characterized in that the control fluid (40) is constantly directed into the region of the electronics (30, 32, 38).

19. Method of cooling the electronics (30, 32, 38) of a control device (16) according to claim 15,
characterized in that the temperature in the region of the electronics (30, 32, 38) is measured and, after a limit temperature has been exceeded, the control fluid (40) is directed into the region of the electronics (30, 32, 38).

20. Methcd of cooling the electronics (30, 32, 38) of a control device (16) according to one of claims 15 to 18, as a gearbox control device for a motor vehicle (6) having a gearbox (2), the control electronics (30, 32, 38) being disposed in or at the gearbox (2),
characterized in that the supply of the control fluid (40) is continued after parking of the vehicle (6) in order to dissipate retained heat in the region of the electronics (30, 32, 38).

21. Method of cooling the electronics (30, 32, 38) of a control device (16) according to at least one of claims 15 to 19, characterized in that the control fluid (40) is directed through a cooling plate (36), on which the electronics (30, 32, 38) are disposed.

22. Method of cooling the electronics (30, 32, 38) of a control device (16) according to at least one of claims 15 to 20, characterized in that the control fluid (40) is directed by fluid-feeding means into the region of the electronics (30, 32, 38).

23. Method of cooling the electronics (30, 32, 38) of a control device (16) according to claim 21,
characterized in that the control fluid (40) is fed by a fan.

24. Method of cooling the electronics (30, 32, 38) of a control device (16) according to claim 21,
characterized in that the control fluid (40) is fed by a pump.

25. Method of cooling the electronics (30, 32, 38) of a control device (16) according to at least one of claims 15 to 23, characterized in that air is used as a control fluid (40).

26. Method of cooling the electronics (30, 32, 38) of a control device (16) according to at least one of claims 15 to 23, characterized in that hydraulic cil is used as a control fluid.

## Revendications

1. Dispositif de commande (16) comportant des moyens de commande (16, 18) actionnés par un fluide (40) et une électronique de commande (30, 32, 38) affectée aux fonctions, notamment un dispositif de commande d'une boîte de vitesses pour un véhicule automobile (6) avec une boîte de vitesses (2), dans lequel l'électronique de commande (30, 32, 38) est disposée dans ou sur la boîte de vitesses (2), **caractérisé** en ce que l'électronique de commande (30, 32, 38) est refroidie par un refroidissement forcée du fait de l'alimentation ciblée du fluide de commande (40).

2. Dispositif de commande (16) selon la revendication 1, **caractérisé** en ce que l'alimentation du fluide est conçue de telle façon que le fluide de commande (40) est amené à la boîte de vitesses lors de l'actionnement des moyens de commande (16, 18).

3. Dispositif de commande (16) selon la revendication 1, **caractérisé** en ce que l'alimentation en fluide est conçue de telle façon que le fluide de commande (40) est alimenté en permanence.

4. Dispositif de commande (16) selon la revendication 1, **caractérisé** en ce que l'alimentation en fluide est conçue de telle façon que le fluide de commande (40) est alimenté en fonction de la température.

5. Dispositif de commande (16) selon l'une des revendications 1 à 4 en tant que dispositif de commande de la boîte de vitesses pour un véhicule automobile (6) avec une boîte de vitesses (2), dans lequel l'électronique de commande (30, 32, 38) est disposée dans ou sur la boîte de vitesses (2), **caractérisé** en ce que l'alimentation du fluide de commande (40) peut continuer après l'arrêt du véhicule (6).

6. Dispositif de commande (16) selon l'une des revendications 1 à 5, **caractérisé** en ce que l'électronique de commande (30, 32, 38) est réalisée de telle manière que le fluide de commande (40) circule à travers l'électronique de commande (30, 32, 38).

7. Dispositif de commande (16) selon l'une des revendications 1 à 5, **caractérisé** en ce que l'électronique de commande (30, 32, 38) est disposée sur une plaque de refroidissement (36) dans laquelle circule le fluide de commande (40).

8. Dispositif de commande (16) selon la revendication 7, **caractérisé** en ce qu'entre l'électronique de commande (30, 32, 38) et la plaque de refroidissement (36) sont prévus des moyens qui améliorent la conductibilité thermique.

9. Dispositif de commande (16) selon la revendication 8, **caractérisé** en ce que le moyen est une pâte conductrice de la chaleur.

10. Dispositif de commande (16) selon l'une des revendications 1 à 9, **caractérisé** en ce que le fluide de commande (40) est en circulation forcée du fait d'un dispositif de refoulement.

11. Dispositif de commande (16) selon la revendication 10, **caractérisé** en ce que le dispositif de refoulement est un ventilateur.

12. Dispositif de commande (16) selon la revendication 10, **caractérisé** en ce que le dispositif de refoulement est une pompe.

13. Dispositif de commande (16) selon au moins l'une des revendications précédentes, **caractérisé** en ce que le fluide de commande (40) est de l'air.

14. Dispositif de commande (16) selon au moins l'une des revendications précédentes 1 à 12, **caractérisé** en ce que le fluide de commande (40) est de l'huile hydraulique.

15. Dispositif de commande (16) selon au moins l'une des revendications précédentes, **caractérisé** en ce que l'électronique de commande (30, 32, 38) est réalisée de façon à être isolée de la chaleur des autres éléments du dispositif de commande (16, 18) ou de la boîte de vitesses (2).

16. Procédé de refroidissement de l'électronique (30, 32, 38) d'un dispositif de commande (16) comportant des moyens de commande (16, 18) actionnés par un fluide de commande (40), notamment un dispositif de commande pour un véhicule automobile (6) avec une boîte de vitesses (2), **caractérisé** en ce que le fluide de commande (40) est dirigé de manière ciblée dans la zone de l'électronique (30, 32, 38) afin d'être refroidi.

17. Procédé de refroidissement de l'électronique (30, 32, 38) d'un dispositif de commande (16) selon la revendication 15,**caractérisé** en ce que le fluide de commande (40) est amené dans la zone de l'électronique (30, 32, 38) lors de l'actionnement des moyens de commande (16, 18).

18. Procédé de refroidissement de l'électronique (30, 32, 38) d'un dispositif de commande (16) selon la revendication 15, **caractérisé** en ce que le fluide de commande (40) est amené en permanence dans la zone de l'électronique (30, 32, 38).

19. Procédé de refroidissement de l'électronique (30, 32, 38) d'un dispositif de commande (16) selon la revendication 15,**caractérisé** en ce que la température dans la zone de l'électronique (30, 32, 38) est mesurée, et en ce que le fluide de commande (40) est amené dans la zone de l'électronique (30, 32, 38) après dépassement d'une température limite.

20. Procédé de refroidissement de l'électronique (30, 32, 38) d'un dispositif de commande (16) selon l'une des revendications 15 à 18 en tant que dispositif de commande de l'embrayage pour un véhicule automobile (6) avec une boîte de vitesses (2), dans lequel l'électronique de commande (30, 32, 38) est disposée dans ou sur la boîte de vitesses (2), **caractérisé** en ce que l'alimentation du fluide de commande (40) est poursuivie après l'arrêt du véhicule (6) afin d'évacuer la chaleur accumulée dans la zone de l'électronique (30, 32, 38).

21. Procédé de refroidissement de l'électronique (30, 32, 38) d'un dispositif de commande (16) selon au moins l'une des revendications 15 à 19, **caractérisé** en ce que le fluide de commande (40) circule à travers une plaque de refroidissement (36) sur laquelle est agencée l'électronique (30, 32, 38).

22. Procédé de refroidissement de l'électronique (30, 32, 38) d'un dispositif de commande (16) selon au moins l'une des revendications 15 à 20, **caractérisé** en ce que le fluide de commande (40) est amené par des moyens de refoulement dans la zone de l'électronique (30, 32, 38).

23. Procédé de refroidissement de l'électronique (30, 32, 38) d'un dispositif de commande (16) selon la revendication 21, **caractérisé** en ce le fluide de commande est refoulé par un ventilateur.

24. Procédé de refroidissement de l'électronique (30, 32, 38) d'un dispositif de commande (16) selon la revendication 21, **caractérisé**en ce que le fluide de commande est refoulé par une pompe.

25. Procédé de refroidissement de l'électronique (30, 32, 38) d'un dispositif de commande (16) selon au moins l'une des revendications 15 à 23, **caractérisé** en ce que c'est de l'air qui est utilisé comme fluide de commande (40).

26. Procédé de refroidissement de l'électronique (30, 32, 38) d'un dispositif de commande (16) selon au moins l'une des revendications 15 à 23, **caractérisé** en ce que de l'huile hydraulique est utilisée comme fluide de commande.
